# EUROPEAN PATENT APPLICATION

(11) **EP 4 819 421 A1**
(43) Date of publication of application: **07.10.2026**
(21) Application number: 25200736.4
(22) Date of filing: 08.09.2025
(51) Int. Cl.: H02G 5/00, H01B 7/08, B60R 16/02

(54) **CONDUCTOR ASSEMBLY**

(30) Priority: 01.04.2025 US 202563781427 P; 18.07.2025 US 202519273285
(71) Applicant: Aptiv Manufacturing Management Services GmbH, 8200 Schaffhausen (CH)
(72) Inventor: PETERSON, David R., 8200 Schaffhausen (CH); DEAN, Robert, 8200 Schaffhausen (CH); WALKOWSKI, Jakub, 8200 Schaffhausen (CH); MICHAEL, Jeffrey, 8200 Schaffhausen (CH); VANSUCH, Stephen, 8200 Schaffhausen (CH); SUDIK JR., Joseph, 8200 Schaffhausen (CH)
(74) Representative: Bardehle Pagenberg Partnerschaft mbB Patentanwälte Rechtsanwälte

(57) **Abstract**

A conductor apparatus (10) includes at least one insulated conductor (12, 12-1, 12-2), a protective layer (14, 14a), and an electromagnetic interference (EMI) shield. The at least one insulated conductor (12, 12-1, 12-2) extends in a first direction (30a, 30-1). The protective layer (14, 14a) surrounds the at least one insulated conductor (12, 12-1, 12-2). The protective layer (14, 14a) includes a first lateral portion (40a, 40-1) and a second lateral portion (40-2) including an adhesive (42) coupled to the first lateral portion (40a, 40-1). The first lateral portion (40a, 40-1) and the second lateral portion (40-2) define an edge (44, 44a, 44-2) extending in the first direction (30a, 30-1). The EMI shield is disposed between the at least one insulated conductor (12, 12-1, 12-2) and the protective layer (14, 14a).

## Description

### Cross-Reference to Related Applications

This application claims the benefit of U.S. Provisional Application No. 63/781,427 filed April 1, 2025, the entire disclosure of which is incorporated by reference.

### Field

The present disclosure relates to a conductor assembly and more particularly to a conductor assembly that may be used with a vehicle.

### Background

Modern vehicles rely on electrical conductor assemblies to maintain communication between electronic components. These assemblies must protect against environmental and electromagnetic disturbances to ensure system reliability. To reduce electromagnetic interference (EMI), a conductive shield is often placed around one or more conductors. However, if the shield is able to move relative to the conductors, its effectiveness and mechanical stability may be compromised. While known conductor assemblies have proven acceptable for their intended purpose, a continuous need for improvement remains in the pertinent art to provide enhanced EMI shielding and mechanical durability.

The background description provided here is for the purpose of generally presenting the context of the disclosure. Work of the presently named inventors, to the extent it is described in this background section, as well as aspects of the description that may not otherwise qualify as prior art at the time of filing, are neither expressly nor impliedly admitted as prior art against the present disclosure.

### Summary

One aspect of the disclosure provides a conductor apparatus. The conductor apparatus includes at least one insulated conductor, a protective layer, and an electromagnetic interference (EMI) shield. The at least one insulated conductor extends in a first direction. The protective layer surrounds the at least one insulated conductor. The protective layer includes a first lateral portion and a second lateral portion including an adhesive coupled to the first lateral portion. The first lateral portion and the second lateral portion define an edge extending in the first direction. The EMI shield is disposed between the at least one insulated conductor and the protective layer.

Further areas of applicability of the present disclosure will become apparent from the detailed description, the claims, and the drawings. The detailed description and specific examples are intended for purposes of illustration only and are not intended to limit the scope of the disclosure.

### Brief Description Of The Drawings

The present disclosure will become more fully understood from the detailed description and the accompanying drawings.
FIG. 1 is a perspective view of an example conductor assembly in accordance with the principles of the present disclosure.
FIG. 2 is a perspective view of a portion of the conductor assembly of FIG. 1.
FIG. 3 is a perspective view of an example conductor assembly in accordance with the principles of the present disclosure.
FIG. 4 is an exploded view of the conductor assembly of FIG. 3.
FIG. 5 is a front view of the conductor assembly of FIG. 3.
In the drawings, reference numbers may be reused to identify similar and/or identical elements.

### Detailed Description

Electrical current may be transmitted between two devices using various types of conductors, including round wire, rectangular busbars, circular busbars, and flat flexible cables. These conductors may be insulated with a nonconductive material such as polyvinyl chloride (PVC), cross-linked polyethylene (XLPE), silicone, or other insulating compounds. To reduce electromagnetic interference (EMI), a braided conductive shield may be applied over the insulated conductor, often positioned between two layers of insulation.

A conductive material, such as copper or aluminum, may be extruded and formed onto a reel. The conductor may then be unspooled and passed through a separate extruder that applies a nonconductive insulation layer. A thin layer of conductive material may be produced separately to serve as an EMI shield. This shielding layer may have a width greater than that of the insulated conductor.

The insulated conductor and shielding material may be cut to length and stacked so that the shielding material forms the outermost layers of the assembly. A pair of abrasion-resistant tapes-or other robust tapes-with widths greater than the shielding material may also be cut to length and may be applied to the outer surfaces of the assembly. The stacked conductors and shielding may then be wrapped laterally (e.g., orthogonal to their width) with the tape. This lateral wrapping causes the overhanging portions of the upper and lower shielding layers to contact one another, completing the EMI shielding circuit. The overhanging tape edges may be joined together using adhesive-to-adhesive bonding.

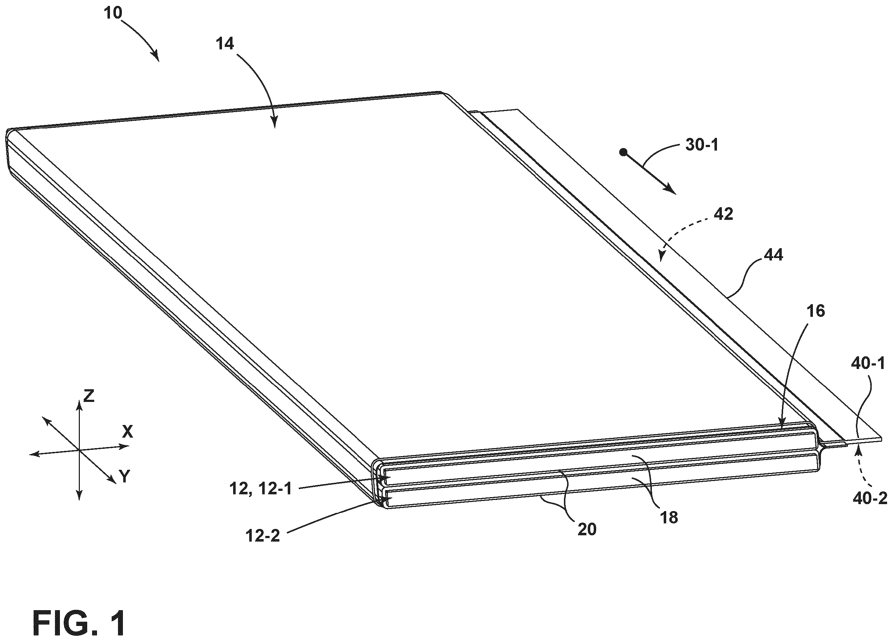

With reference to FIG. 1, an example conductor assembly 10 (e.g., a conductor apparatus) is shown. In various implementations, the assembly 10 includes at least one insulated conductor 12, a protective layer 14, and/or an electromagnetic interference (EMI) shield 16, among others.

In various implementations, the assembly 10 includes a first insulated conductor 12-1 and a second insulated conductor 12-2. The second insulated conductor 12-2 may engage the first insulated conductor 12-1. For example, the first and second insulated conductors 12-1, 12-2 may define a stacked configuration. Alternatively, the first and second insulated conductors 12-1, 12-2 may define a side-by-side configuration. In various implementations, an insulated conductor 12 (e.g., insulated conductor 12-1, 12-2) includes an electrical conductor 18 (e.g., a busbar, a cable, a wire, etc.) and an insulation layer 20. The insulation layer 20 may surround the conductor 18. While the conductor apparatus 10 is generally shown and described herein as including two insulated conductors 12, the conductor apparatus 10 may include more or less than two insulated conductors 12.

In various implementations, the first and second insulated conductors 12-1, 12-2 extend in a first direction 30-1 (e.g., Y-direction). In various implementations, the protective layer 14 surrounds the first and second insulated conductors 12-1, 12-2 and/or the EMI shield 16. The protective layer 14 may form a C-shape in a cross section taken orthogonal to the first direction (e.g., X-direction). The protective layer 14 may be an abrasion resistant tape. The protective layer 14 inhibits the EMI shield 16 from moving relative to the first and second insulated conductors 12-1, 12-2.

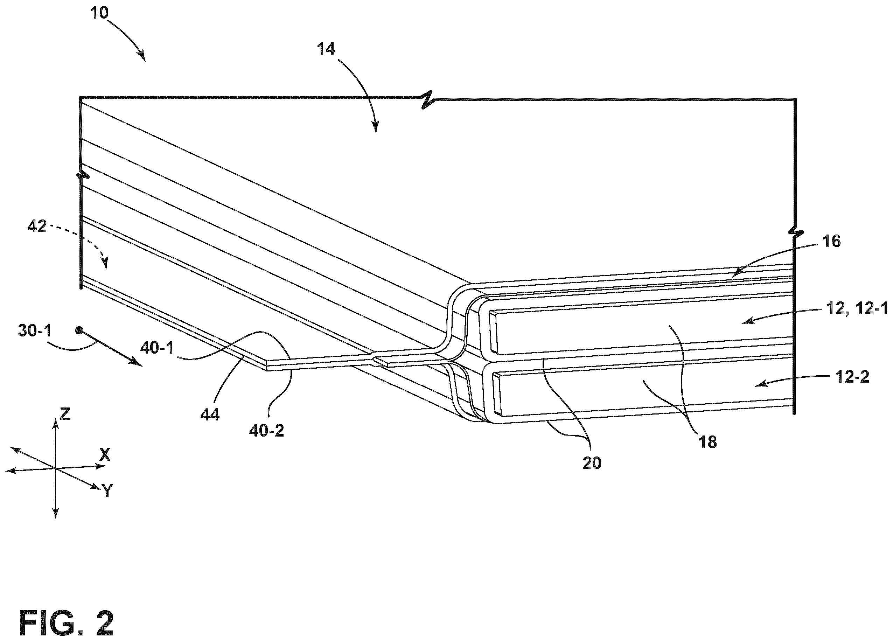

With reference to FIG. 2, in various implementations, the protective layer includes a first lateral portion 40-1 and a second lateral portion 40-2. At least one of the first lateral portion 40-1 or the second lateral portion 40-2 includes an adhesive 42 coupled to the other of the first lateral portion 40-1 or the second lateral portion 40-2.

In various implementations, the first and second lateral portions 40-1, 40-2 define an edge 44. The edge 44 may extend in the first direction 30-1. In various implementations, the EMI shield 16 is disposed between the first and second insulated conductors 12-1, 12-2 and the protective layer 14.

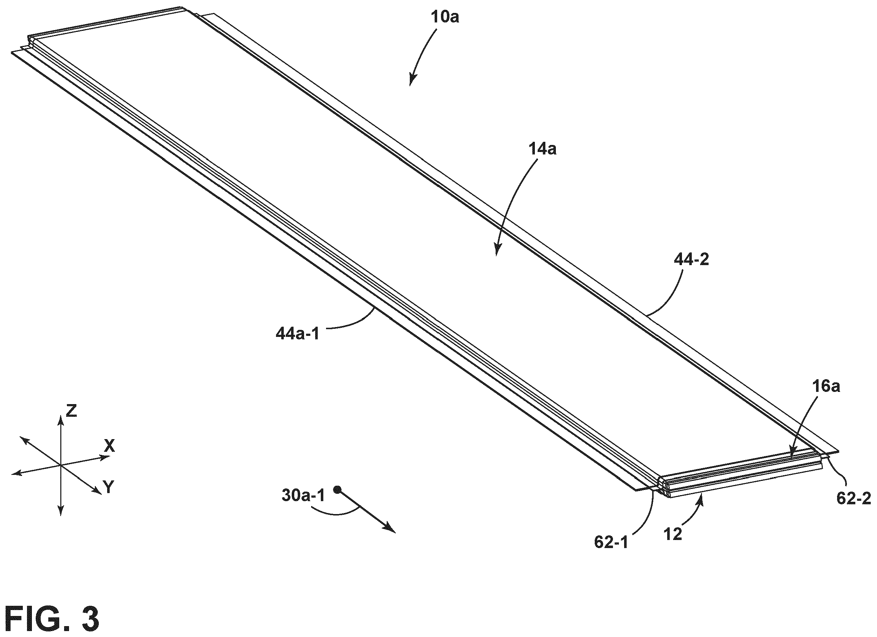

With reference to FIGS. 3-5, an example conductor assembly 10a (e.g., a conductor apparatus) is shown. In view of the similarity in structure and function of the assembly 10a to the assembly 10, like reference numerals are used hereinafter and in the drawings to identify like components while like reference numerals containing letter extensions (e.g., "a") are used to identify those components that have been modified.

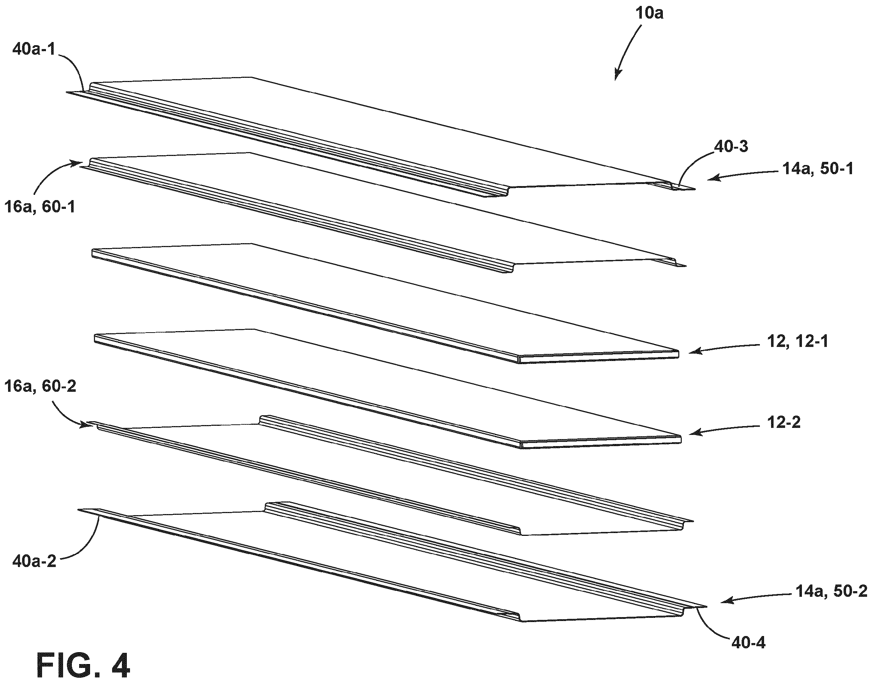

In various implementations, the assembly 10a includes at least one insulated conductor 12, a protective layer 14a, and/or an electromagnetic interference (EMI) shield 16a, among others. Referring now to FIG. 4, in various implementations, the protective layer 14a includes a first member 50-1 and a second member 50-2. The first member 50-1 may include a first lateral portion 40a-1 and the second member 50-2 may include a second lateral portion 40a-2.

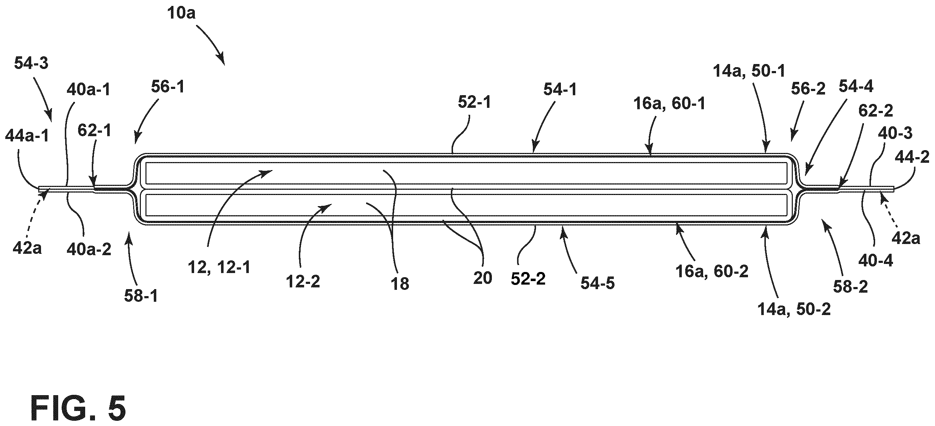

In various implementations, the first member 50-1 includes a third lateral portion 40-3 opposite the first lateral portion 40a-1. The second member 50-2 may include a fourth lateral portion 40-4 opposite the second lateral portion 40a-2. Referring now to FIG. 5, the first member 50-1 may include a first central portion 52-1 and the second member 50-2 may include a second central portion 52-2. The first central portion 52-1 may be disposed on a first side 54-1 of the at least one insulated conductor 12 and the second central portion 52-2 may be disposed on a second side 54-2 of the insulated conductor 12. The second side 54-2 may be opposite the first side 54-1.

In various implementations, the first lateral portion 40a-1 may be disposed on a first side 56-1 of the first central portion 52-1 and the third lateral portion 40-3 may be disposed on a second side 56-2 of the first central portion 52-1. The second side 56-2 may be opposite the first side 56-1.

In various implementations, the second lateral portion 40a-2 may be disposed on a first side 58-1 of the second central portion 52-2 and the fourth lateral portion 40-4 may be disposed on a second side 58-2 of the second central portion 52-2. The second side 58-2 may be opposite the first side 58-1.

In various implementations, the first and second lateral portions 40a-1, 40a-2 are disposed on a third side 54-3 of the at least one insulated conductor 12. The third and fourth lateral portions 40-3, 40-4 may be disposed on a fourth side 54-4 of the at least one insulated conductor 12. The third side 54-3 may extend between the first and second sides 54-1, 54-2. The fourth side 54-4 may be opposite the third side 54-3. The first and second sides 54-1, 54-2 may be disposed between the third side 54-3 and the fourth side 54-4.

In various implementations, at least one of the first lateral portion 40a-1 or the second lateral portion 40a-2 includes an adhesive 42a coupled to the other of the first lateral portion 40a-1 or the second lateral portion 40a-2. In various implementations, at least one of the third lateral portion 40-3 or the fourth lateral portion 40-4 includes an adhesive 42a coupled to the other of the third lateral portion 40-3 or the fourth lateral portion 40-4.

In various implementations, the first and second lateral portions 40a-1, 40a-2 define a first edge 44a-1. The first edge 44a-1 may extend in a first direction 30a-1 (see, e.g., FIG. 3). The third lateral portion 40-3 and the fourth lateral portion 40-4 may define a second edge 44-2. The second edge 44-2 may be parallel to the first edge 44a-1.

With reference to FIGS. 3 and 4, in various implementations, the EMI shield 16a includes a first layer 60-1 and a second layer 60-2. Portions of the first and second layers 60-1, 60-2 may be disposed between the first and second lateral portions 40a-1, 40a-2. Addition portions of the first and second layers 60-1, 60-2 may be disposed between the third and fourth lateral portions 40-3, 40-4.

In various implementations, the first and second layers 60-1, 60-2 define a first end 62-1 and a second end 62-1 opposite the first end 62-1. The first and second ends 62-1, 62-2 may extend in the first direction 30a-1. The first end 62-1 may be offset inwardly relative to the first edge 44a-1. The second end 62-1 may be offset inwardly relative to the second edge 44-2. The first end 62-1 may be disposed between the at least one insulated conductor 12 and the first edge 44a-1. The second end 62-2 may be disposed between the at least one insulated conductor 12 and the second edge 44-2.

With reference to FIGS. 1, 3, and 5, a method of manufacturing a conductor assembly (e.g., conductor assembly 10, 10a) will be described. Manufacturing the conductor assembly may include extruding a conductor (e.g., conductor 12) and wrapping the conductor onto a reel. The method may also include unwrapping the conductor from the reel and applying a nonconductive insulation layer (e.g., insulation layer 20). For example, the method may include passing the conductor through an extruder that applies the nonconductive insulation layer. The method may also include applying a thin layer of conductive material (e.g., shield 16, 16a) over the conductor and/or insulation layer. The method may further include cutting the conductor, insulation layer, and/or shield layer to a length predetermined length and/or stacking the insulated conductors so that the shielding material forms the outermost layers of the assembly.

The method may further include applying a protective layer (e.g., layer 14, 14a) over the conductor, insulation layer, and/or shield. For example, the method may include wrapping the conductor, insulation layer, and/or shield in the protective layer (e.g., the first member 50-1 and/or the second member 50-2) such that a lateral portion (e.g., lateral portion 40-1, 40a-1, 40-2, 40a-2, 40-3, 40-4) of the protective layer is coupled to another lateral portion (e.g., lateral portion 40-1, 40a-1, 40-2, 40a-2, 40-3, 40-4) to define an edge (e.g., edge 44, 44a-1, 44-2) extending along the length of the assembly, such that overhanging portions of the shielding layers to contact one another between the lateral portions. The method may also include joining the lateral portions to one another using adhesive-to-adhesive bonding.

The foregoing description is merely illustrative in nature and is in no way intended to limit the disclosure, its application, or uses. The broad teachings of the disclosure can be implemented in a variety of forms. Therefore, while this disclosure includes particular examples, the true scope of the disclosure should not be so limited since other modifications will become apparent upon a study of the drawings, the specification, and the following claims. In the written description and claims, one or more steps within a method may be executed in a different order (or concurrently) without altering the principles of the present disclosure. Unless indicated otherwise, numbering or other labeling of instructions or method steps is done for convenient reference, not to indicate a fixed order. Numerical terms, such as "first," "second," and "third," may be used in the disclosure and claims as unique labels: they are not used to imply a sequence or order unless the context clear indicates otherwise. In other words, a "second element" could be relabeled as a "first element" without departing from the principles of the present disclosure. Further, the presence of a "second element" does not imply or require the presence of a "first element."

Unless the context clearly indicates otherwise, the singular articles "a," "an," and "the" before a noun do not restrict the noun to a single instance. The verbs "comprise," "include," and "have" are inclusive and therefore specify the presence of elements without excluding the presence of one or more additional elements.

Further, although each of the embodiments is described above as having certain features, any one or more of those features described with respect to any embodiment of the disclosure can be implemented in and/or combined with features of any of the other embodiments, even if that combination is not explicitly described. In other words, the described embodiments are not mutually exclusive, and permutations of one or more embodiments with one another remain within the scope of this disclosure.

Spatial and functional relationships between elements are described using various terms, including "connected," "coupled," "engaged," "adjacent," "next to," "on top of," "above," "below," and "disposed." Unless explicitly described as being "direct," when a relationship between first and second elements is described in the above disclosure, that relationship encompasses a direct relationship where no other intervening elements are present between the first and second elements as well as an indirect relationship where one or more intervening elements are present between the first and second elements.

The term "set" generally means a grouping of one or more elements. The elements of a set do not necessarily need to have any characteristics in common or otherwise belong together. However, in various implementations a "set" may, in certain circumstances, be the empty set (in other words, the set has zero elements in those circumstances). As an example, a set of search results resulting from a query may, depending on the query, be the empty set. In contexts where it is not otherwise clear, the term "non-empty set" can be used to explicitly denote exclusion of the empty set - that is, a non-empty set will always have one or more elements.

A "subset" of a first set generally includes some of the elements of the first set. In various implementations, a subset of the first set is not necessarily a proper subset: in certain circumstances, the subset may be coextensive with (equal to) the first set (in other words, the subset may include the same elements as the first set). In contexts where it is not otherwise clear, the term "proper subset" can be used to explicitly denote that a subset of the first set must exclude at least one of the elements of the first set. Further, in various implementations, the term "subset" does not necessarily exclude the empty set. As an example, consider a set of candidates that was selected based on first criteria and a subset of the set of candidates that was selected based on second criteria; if no elements of the set of candidates met the second criteria, the subset may be the empty set. In contexts where it is not otherwise clear, the term "non-empty subset" can be used to explicitly denote exclusion of the empty set.

The phrase "at least one of A, B, and C" should be construed to mean a logical (A OR B OR C), using a non-exclusive logical OR, and should not be construed to mean "at least one of A, at least one of B, and at least one of C." The phrase "at least one of A, B, or C" should be construed to mean a logical (A OR B OR C), using a non-exclusive logical OR. The phrase "A, B, and/or C" should be construed in the same way as the phrase "at least one of A, B, and C."

The examples of the present disclosure may include one or more components such as connectors, terminals, conductors, insulating members, shielding structures, housings, retention features, and sealing elements, among others, as well as corresponding systems and assemblies. These examples may be configured to facilitate electrical signal transmission, power delivery, electromagnetic compatibility, or mechanical retention under various environmental conditions, such as thermal cycling, vibration, or exposure to fluids. Disclosed components, systems and assemblies, among others, may be arranged modularly or integrally to accommodate various system architectures and routing constraints.

Disclosed components may be fabricated from thermoplastics, thermoset resins, composites, or metals, optionally treated or coated for corrosion resistance, electromagnetic interference shielding, or biocompatibility for use in various applications, system, and environments, among others. In particular, in medical applications, sterilizable and/or biocompatible materials may be used. In solar or renewable energy systems, UV-resistant and/or weatherproof materials may be incorporated. In aerospace and space-based systems, weight reduction may be prioritized, and high-performance materials such as polyimide films, fluoropolymers, or ceramic composites may be employed.

Disclosed components, systems and assemblies, among others, may be designed for automated assembly, including robotic insertion, ultrasonic welding, or crimping techniques. Adaptations may be made to ensure compliance with relevant standards, including International Organization for Standardization, Military Specification, Society of Automotive Engineers, Food and Drug Administration, or International Electrotechnical Commission, depending on the target industry or market. In this regard, while examples and embodiments of the present disclosure may be illustrated and described herein in the context of an automobile, it will be appreciated that such examples and embodiments are equally suited for other applications, systems, environments, industries, and markets, among others. For example, implementations of the present disclosure that relate generally to electrical components and assemblies, and more particularly to connectors, terminals, wiring harnesses, and integrated electrical interconnection systems, among others, are suitable for a wide range of environments and applications.

While exemplary embodiments described herein may reference automotive use cases, the disclosed technology is not limited thereto and may be employed in any system requiring, for example, robust, secure, reliable, and/or durable electrical connectivity, among others. In particular, the structures, materials, and configurations disclosed may be adapted for use in aerospace systems, medical devices, consumer electronics, industrial automation, energy distribution networks, solar and other renewable energy installations, marine vessels, and space exploration platforms. Accordingly, although specific embodiments may describe automotive implementations, the principles disclosed herein are equally applicable to any system requiring robust electrical interconnection, and claims directed to any system, application, and/or environmental domain are, and will be, contemplated by one of skill in the art.

Various example embodiments of the invention are described in the following clauses.

Clause 1: A conductor apparatus comprising: at least one insulated conductor extending in a first direction; a protective layer surrounding the at least one insulated conductor and including a first lateral portion and a second lateral portion including an adhesive coupled to the first lateral portion, the first lateral portion and the second lateral portion defining an edge extending in the first direction; and an electromagnetic interference (EMI) shield disposed between the at least one insulated conductor and the protective layer.

Clause 2: The conductor apparatus of clause 1, wherein the protective layer includes: a first member including the first lateral portion; and a second member including the second lateral portion.

Clause 3: The conductor apparatus of clause 2, wherein: the first member includes a third lateral portion opposite the first lateral portion; the second member includes a fourth lateral portion opposite the second lateral portion; and one of the third lateral portion or the fourth lateral portion includes an additional adhesive coupled to the other of the third lateral portion or the fourth lateral portion.

Clause 4: The conductor apparatus of clause 3, wherein the EMI shield includes a first layer and a second layer disposed between the third lateral portion and the fourth lateral portion.

Clause 5: The conductor apparatus of clause 3, wherein the third lateral portion and the fourth lateral portion define an additional edge.

Clause 6: The conductor apparatus of clause 5, wherein the edge is parallel to the additional edge.

Clause 7: The conductor apparatus of clause 3, wherein: the protective layer includes a central portion disposed on a first side of the insulated conductor, the first lateral portion is disposed on a first side of the central portion, and the third lateral portion is disposed on a second side of the central portion.

Clause 8: The conductor apparatus of clause 7, wherein the first and second lateral portions are disposed on a second side of the insulated conductor.

Clause 9: The conductor apparatus of clause 8, wherein the third and fourth lateral portions are disposed on a third side of the insulated conductor.

Clause 10: The conductor apparatus of clause 9, wherein the third side of the insulated conductor is opposite the second side of the insulated conductor.

Clause 11: The conductor apparatus of clause 9, wherein the first side of the insulated conductor is disposed between the third side of the insulated conductor and the second side of the insulated conductor.

Clause 12: The conductor apparatus of any of clauses 1 through 11, wherein the EMI shield is disposed between the first lateral portion and the second lateral portion.

Clause 13: The conductor apparatus of any of clauses 1 through 12, wherein the EMI shield defines an end extending in the first direction.

Clause 14: The conductor apparatus of clause 13, wherein the end is offset inwardly relative to the edge.

Clause 15: The conductor apparatus of clause 13, wherein the end is disposed between the insulated conductor and the edge.

Clause 16: The conductor apparatus of any of clauses 1 through 15, further comprising an additional insulated conductor engaging the insulated conductor.

Clause 17: The conductor apparatus of clause 16, wherein the insulated conductor and the additional insulated conductor define a stacked configuration.

Clause 18: The conductor apparatus of any of clauses 1 through 17, wherein the protective layer is an abrasion resistant tape.

Clause 19: The conductor apparatus of any of clauses 1 through 18, wherein the protective layer forms a C-shape in a cross section taken orthogonal to the first direction.

Clause 20: The conductor apparatus of any of clauses 1 through 19, wherein the protective layer is configured to inhibit the EMI shield from moving relative to the insulated conductor.

## Claims

1. A conductor apparatus (10) comprising:
at least one insulated conductor (12, 12-1, 12-2) extending in a first direction (30a, 30-1);
a protective layer (14, 14a) surrounding the at least one insulated conductor (12, 12-1, 12-2) and including a first lateral portion (40a, 40-1) and a second lateral portion (40-2) including an adhesive coupled to the first lateral portion (40a, 40-1), the first lateral portion (40a, 40-1) and the second lateral portion (40-2) defining an edge (44, 44a, 44-2) extending in the first direction (30a, 30-1); and
an electromagnetic interference (EMI) shield disposed between the at least one insulated conductor (12, 12-1, 12-2) and the protective layer (14, 14a).

2. The conductor apparatus (10) of claim 1 wherein the protective layer (14, 14a) includes:
a first member (50-1) including the first lateral portion (40a, 40-1); and
a second member (50-2) including the second lateral portion (40-2).

3. The conductor apparatus (10) of claim 2 wherein:
the first member (50-1) includes a third lateral portion (40-3) opposite the first lateral portion (40a, 40-1);
the second member (50-2) includes a fourth lateral portion (40-4) opposite the second lateral portion (40-2); and
one of the third lateral portion (40-3) or the fourth lateral portion (40-4) includes an additional adhesive coupled to the other of the third lateral portion (40-3) or the fourth lateral portion (40-4).

4. The conductor apparatus (10) of claim 3 wherein the EMI shield (16, 16a) includes a first layer (60-1) and a second layer (60-2) disposed between the third lateral portion (40-3) and the fourth lateral portion (40-4), and/or wherein the third lateral portion (40-3) and the fourth lateral portion (40-4) define an additional edge.

5. The conductor apparatus (10) of claim 4 wherein the edge is parallel to the additional edge.

6. The conductor apparatus (10) of any one of the preceding claims 3 to 5 wherein:
the protective layer (14, 14a) includes a central portion (52-1, 52-2) disposed on a first side (54-1) of the insulated conductor (12, 12-1, 12-2),
the first lateral portion (40a, 40-1) is disposed on a first side (54-1) of the central portion (52-1, 52-2), and
the third lateral portion (40-3) is disposed on a second side (54-2) of the central portion (52-1, 52-2).

7. The conductor apparatus (10) of claim 6 wherein the first and second lateral portions (40-1, 40-2) are disposed on a second side (54-2) of the insulated conductor (12, 12-1, 12-2), and wherein preferably the third and fourth lateral portions (40-4) are disposed on a third side (54-3) of the insulated conductor (12, 12-1, 12-2).

8. The conductor apparatus (10) of claim 7 wherein the third side (54-3) of the insulated conductor (12, 12-1, 12-2) is opposite the second side (54-2) of the insulated conductor (12, 12-1, 12-2).

9. The conductor apparatus (10) of claim 7 or 8 wherein the first side (54-1) of the insulated conductor (12, 12-1, 12-2) is disposed between the third side (54-3) of the insulated conductor (12, 12-1, 12-2) and the second side (54-2) of the insulated conductor (12, 12-1, 12-2).

10. The conductor apparatus (10) of any one of the preceding claims wherein the EMI shield (16, 16a) is disposed between the first lateral portion (40a, 40-1) and the second lateral portion (40-2).

11. The conductor apparatus (10) of any one of the preceding claims wherein the EMI shield (16, 16a) defines an end (62-1, 62-2) extending in the first direction (30a, 30-1), and wherein the end (62-1, 62-2) is preferably offset inwardly relative to the edge (44).

12. The conductor apparatus (10) of claim 11 wherein the end (62-1, 62-2) is disposed between the insulated conductor (12, 12-1, 12-2) and the edge (44).

13. The conductor apparatus (10) of any one of the preceding claims further comprising an additional insulated conductor engaging the insulated conductor (12, 12-1, 12-2), and wherein the insulated conductor (12, 12-1, 12-2) and the additional insulated conductor optionally define a stacked configuration.

14. The conductor apparatus (10) of any one of the preceding claims wherein the protective layer (14, 14a) is an abrasion resistant tape, and/or wherein the protective layer (14, 14a) forms a C-shape in a cross section taken orthogonal to the first direction (30a, 30-1).

15. The conductor apparatus (10) of any one of the preceding claims wherein the protective layer (14, 14a) is configured to inhibit the EMI shield (16, 16a) from moving relative to the insulated conductor (12, 12-1, 12-2).
